# FASCICULE DE BREVET EUROPEEN

(11) **EP 3 436 873 B1**
(45) Date de publication et mention de la délivrance du brevet: **24.06.2020**
(21) Numéro de dépôt: 17719651.6
(22) Date de dépôt: 29.03.2017
(51) Int. Cl.: G03F 7/00, G03F 7/004, G03F 7/038, B29C 67/00

(54) **COMPOSITION PHOTOSENSIBLE ACTIVABLE PAR ABSORPTION MULTIPHOTONIQUE POUR FABRICATION TRIDIMENSIONNELLE**
DURCH MULTIPHOTONABSORPTION AKTIVIERBARE LICHTEMPFINDLICHE ZUSAMMENSETZUNG FÜR DREIDIMENSIONALE HERSTELLUNG
PHOTOSENSITIVE COMPOSITION THAT CAN BE ACTIVATED BY MULTIPHOTON ABSORPTION FOR THREE-DIMENSIONAL FABRICATION

(30) Priorité: 30.03.2016 FR 1652751
(43) Date de publication de la demande: 06.02.2019
(73) Titulaire: Université Grenoble Alpes, 38400 Saint Martin d'Hères (FR)
(72) Inventeur: STEPHAN, Olivier, 38100 Grenoble (FR); GREDY, Laetitia, 38210 Tullins (FR)
(74) Mandataire: Bronchart, Quentin
(86) Numéro de dépôt international: PCT/FR2017/050719
(87) Numéro de publication internationale: WO 2017/168093

(56) Documents cités:
- WO-A1-2012/018304
- WO-A1-2012/041522
- DE-A1-102009 042 037
- US-A1- 2006 083 890
- DA SILVA GONÇALVES JOYCE LAURA ET AL: "3D printing of natural organic materials by photochemistry", OPTICAL SENSING II, SPIE, 1000 20TH ST. BELLINGHAM WA 98225-6705 USA, vol. 9745, 15 mars 2016 (2016-03-15), pages 97450E-97450E, XP060064761, ISSN: 0277-786X, DOI: 10.1117/12.2217953 ISBN: 978-1-62841-971-9
- ELVIN C M ET AL: "A highly elastic tissue sealant based on photopolymerised gelatin", BIOMATERIALS, ELSEVIER SCIENCE PUBLISHERS BV., BARKING, GB, vol. 31, no. 32, 1 novembre 2010 (2010-11-01), pages 8323-8331, XP027259537, ISSN: 0142-9612 [extrait le 2010-08-01]
- FANCY D A ET AL: "Chemistry for the analysis of protein-protein interactions: Rapid and efficient cross-linking triggered by long wavelength light", PROCEEDINGS OF THE NATIONAL ACADEMY OF SCIENCES, NATIONAL ACADEMY OF SCIENCES, US, vol. 96, no. 11, 25 mai 1999 (1999-05-25), pages 6020-6024, XP002268502, ISSN: 0027-8424, DOI: 10.1073/PNAS.96.11.6020

## Description

### Domaine de l'invention

Le domaine de cette invention est celui de la fabrication de structures tridimensionnelles par absorption multiphotonique.

En particulier, la présente invention concerne une composition photosensible pour la fabrication tridimensionnelle, les structures tridimensionnelles obtenues à partir de cette composition et un procédé de fabrication utilisant l'absorption multiphotonique comme processus d'activation.

### Arrière-plan technologique

En biologie, la fabrication de structures tridimensionnelles est particulièrement utilisée dans le domaine de l'ingénierie tissulaire.

L'ingénierie tissulaire consiste par exemple à créer des substituts de tissus fonctionnels, tels que peau, cartilage ou os, qui peuvent ensuite être implantés in vivo. Ces substituts de tissus fonctionnels sont des matrices (ou supports tridimensionnels poreux) qui ont été colonisées par des cellules. Ces matrices doivent donc avoir des dimensions et des propriétés appropriées pour à la fois permettre la croissance des cellules et pouvoir être par la suite implantées in vivo. En particulier, ces matrices doivent être non toxiques et de préférence biocompatibles, biodégradables ou biorésorbables.

De nombreuses techniques, comme par exemple l'électrospinning, peuvent être utilisées pour produire de telles matrices. Néanmoins, ces techniques ne permettent généralement pas d'avoir une architecture contrôlée et reproductible et/ou avec une bonne résolution de fabrication, ce qui est parfois nécessaire pour les applications souhaitées.

Pour remédier à ces problèmes, l'absorption multiphotonique a été appliquée à la fabrication tridimensionnelle de telles matrices. Cette technique consiste à focaliser une source lumineuse (généralement un laser) sur un matériau photosensible en utilisant une optique de focalisation adaptée. Cela induit une réaction photochimique (généralement une réaction de polymérisation ou de réticulation) là où l'absorption multiphotonique est efficace, c'est-à-dire uniquement au point focal de la source lumineuse, là où l'intensité du la source lumineuse est maximale (phénomène d'absorption non linéaire).

Ainsi, en utilisant un logiciel de conception assistée par ordinateur et en déplaçant le matériau photosensible selon les 3 axes x, y et z, il est possible de fabriquer une structure tridimensionnelle ayant une architecture contrôlée, reproductible et avec une bonne résolution. La fabrication de structures tridimensionnelles par absorption multiphotonique est par exemple décrite dans le chapitre "Tri-dimentional micro-structuration of materials by two-photon induced photochemistry" par P.L. Baldeck, O. Stéphan and C. Andraud publié dans le livre "Basics and applications of photopolymerization reaction (vol 3)" par J.P. Fouassier, X. Allonas Editors, (2010) Research Signpost (chapitre 14, pages 199-220).

Différents matériaux photosensibles peuvent être utilisés pour réaliser des structures tridimensionnelles par absorption multiphotonique.

Le document Joyce Laura Da Silva Gonçalves, et al., "3D printing of natural organic materials by photochemistry," Proc. SPIE 9745, Organic Photonic Materials and Devices XVIII, 97450E, 2016, décrit une composition photosensible comprenant de la gélatine et des molécules d'ADN.

Le document Christopher M. Elvinet, et al., A highly elastic tissue sealant based on photopolymerised gelatin, Biomaterials, Volume 31, Issue 32, 2010, Pages 8323-8331, décrit une composition photosensible comprenant de la gélatine, de l'eau et un photoiniateur.

Le document WO 2012/018304 A1 décrit une composition photosensible comprenant une solution aqueuse de fibrinogène et Ru(II)(bpy)3S208.

Le document WO 2012/041522 A1 décrit un procédé pour l'impression en couche de structures tridimensionnelles, à partir de compositions photosensibles comprenant un polymère photoréticulable.

En outre, ces matériaux photosensibles sont par exemple des résines hybrides organiques-inorganiques ou des résines à base d'acrylates.

Les matériaux Ormocer® sont des résines hybrides organique-inorganique contenant des nanoparticules de silice. Ces résines sont particulièrement utiles pour produire des substituts de tissus d'os car elles sont particulièrement rigides et biocompatibles. Cependant, pour certaines applications, il peut s'avérer utile de pouvoir moduler la rigidité de la matrice, ce qui n'est pas le cas avec ce type de résine.

Les résines à base d'acrylates sont décrites dans de nombreux documents :
Le document WO2015/084735 A2 décrit une composition et un procédé de production de structures tridimensionnelles par absorption à deux photons. La composition est une composition liquide photosensible comprenant un composé polymérisable par voie radicalaire et un photoinitiateur. Le composé polymérisable par voie radicalaire comprend un groupement méthacrylate.

Le document US2012/0098164 décrit une composition photosensible comprenant différents méthacrylates et un photoinitiateur. Cette composition est utilisée pour la fabrication de structures ayant une excellente résolution (quelques µm, voire quelques centaines de nm) par absorption à deux photons.

Le document US2013/0012612 décrit un procédé de production de structures tridimensionnelles biocompatibles par absorption à deux photons. Le matériau utilisé comprend au moins un composé ayant à la fois un groupement organique polymérisable et un groupement biocompatible, biodégradable ou biorésorbable, tel un peptide, par exemple du collagène. Le groupement biocompatible ne peut pas être utilisé tel quel, il est nécessaire de le modifier chimiquement en lui greffant un groupement organique polymérisable. Le groupement organique polymérisable est de préférence un groupement méthacrylate ou acrylate.

La rigidité des structures à base de ces résines méthacrylates ou acrylates est modulable et elle est moindre que celles des structures 3D obtenues à partir de polymères Ormocer®. Cependant, des doutes sont émis quant à la biocompatibilité des structures comprenant des groupements acrylates ou méthacrylates. Or, comme vu ci-dessus, l'utilisation comme matrice pour la culture cellulaire de ces structures dans le cadre de l'ingénierie tissulaire, et de ce fait l'implantation in vivo de ces structures, requiert une biocompatibilité accrue.

### Objectifs

Dans ce contexte, la présente invention vise à satisfaire au moins l'un des objectifs suivants.

Un des objectifs essentiels de l'invention est la fourniture d'une composition photosensible qui peut être utilisée pour produire une structure tridimensionnelle en utilisant l'absorption multiphotonique comme processus d'activation.

Un des objectifs essentiels de l'invention est la fourniture d'une composition photosensible qui peut être utilisée pour produire une structure tridimensionnelle qui soit biodégradable et/ou biocompatible et/ou biorésorbable.

Un autre objectif essentiel de l'invention est la fourniture d'une composition photosensible qui peut être utilisée pour produire une structure tridimensionnelle ayant une excellente résolution, par exemple ayant une épaisseur de trait comprise entre 1 et 5 µm (micromètre).

Un autre objectif essentiel de l'invention est la fourniture d'une composition photosensible qui se présente sous la forme d'un gel à température ambiante.

Un autre objectif essentiel de l'invention est la fourniture d'une composition photosensible qui peut être utilisée pour produire une structure tridimensionnelle qui ait une rigidité contrôlée.

Un autre objectif essentiel de l'invention est la fourniture d'une composition photosensible qui peut être utilisée pour produire une structure tridimensionnelle qui soit autoportée.

Un autre objectif essentiel de l'invention est la fourniture d'une composition photosensible qui peut être utilisée pour produire une structure tridimensionnelle qui puisse être utilisée comme matrice pour la culture cellulaire.

Un autre objectif essentiel de l'invention est la fourniture d'une structure tridimensionnelle obtenue à partir d'une composition photosensible ayant tout ou partie des caractéristiques décrites ci-dessus.

### Brève description de l'invention

Ces objectifs, parmi d'autres, sont atteints par l'invention qui concerne, en premier lieu, une composition photosensible qui peut être utilisée pour produire des structures tridimensionnelles en utilisant l'absorption multiphotonique comme processus d'activation. Cette composition comprend de la gélatine, du collagène, un photoinitiateur soluble dans l'eau, apte à être excité par plusieurs photons et capable de générer de l'oxygène singulet, de l'eau et éventuellement un promoteur d'adhésion cellulaire tel que la fibronectine.

L'invention a également pour objet une structure tridimensionnelle fabriquée avec cette composition photosensible et un procédé de fabrication d'une telle structure tridimensionnelle.

De façon surprenante, il a été découvert qu'une telle composition permettait de fabriquer des structures tridimensionnelles ayant une excellente résolution (épaisseur de trait entre 1 et 5 µm). La présence d'un photoinitiateur capable de générer de l'oxygène singulet, permet la réticulation des protéines contenues dans la composition, en utilisant l'absorption multiphotonique comme processus d'activation. La réaction photochimique induite par le photoinitiateur étant une réaction de réticulation et non de polymérisation, de ce fait, il n'est pas nécessaire de modifier chimiquement les composés en leur greffant un groupement polymérisable, ils peuvent être utilisés tels quels.

La gélatine et le collagène étant des éléments issus de la biomasse, la composition est biocompatible. Par ailleurs, l'association gélatine/collagène permet de produire des structures qui présentent de bonnes propriétés mécaniques et l'ajout d'un promoteur d'adhésion cellulaire tel que la fibronectine améliore l'affinité des cellules pour les structures tridimensionnelles.

Dans tout le présent exposé, « compris entre Z1 et Z2 » signifie que les bornes Z1 et Z2 sont incluses dans l'intervalle [Z1, Z2].

### Brève description des figures

La figure 1 représente une image au microscope d'une structure de type « cage à poules » fabriquée selon l'exemple 3.
Les figures 2A et 2B représentent des images au microscope confocal de structures fabriquées selon l'exemple 4 et utilisées comme matrice pour la culture cellulaire.

### Description détaillée de l'invention

L'invention a donc pour objet une composition photosensible activable par absorption multiphotonique qui peut être utilisée pour produire des structures tridimensionnelles. Cette composition comprend :
- de la gélatine,
- du collagène,
- un photoinitiateur soluble dans l'eau, apte à être excité par plusieurs photons et capable de générer de l'oxygène singulet,
- éventuellement un promoteur d'adhésion cellulaire,
- et de l'eau.

Par « composition photosensible », on entend, par exemple, un mélange sensible au rayonnement lumineux.

Par « absorption multiphotonique », on entend, par exemple, absorption simultanée de deux photons ou plus par une molécule dans un état donné, cette molécule passant alors à un état électronique de plus haute énergie. Cette excitation va induire une réaction photochimique au point focal du la source lumineuse. Dans le cas de la composition photosensible décrite ci-dessus, c'est le photoinitiateur qui absorbe simultanément deux photons, ce qui va induire la réticulation des protéines de la composition au point focal du la source lumineuse. La plupart du temps, l'absorption multiphotonique correspond à une absorption à deux photons.

La gélatine est une protéine qui a un taux élevé de glycine et de proline. Elle est obtenue par hydrolyse partielle du collagène, principalement à partir de collagène contenu dans les peaux et les os d'animaux. Elle peut être de type A (elle provient alors d'un traitement à l'acide du collagène) ou de type B (elle provient alors d'un traitement basique du collagène). Elle peut également être obtenue par traitement enzymatique du collagène. La gélatine utilisée n'a, de préférence, pas été modifiée chimiquement. Selon un mode de réalisation de l'invention, la gélatine utilisée est de la gélatine alimentaire disponible dans le commerce ou de type B, elle peut être sous forme de feuillets, poudre ou granules.

Selon un mode de réalisation de l'invention, la quantité de gélatine contenue dans la composition est comprise entre 10 et 50% en masse par rapport à l'eau, de préférence entre 10 et 30% et encore plus préférentiellement entre 15 et 25%.

Le collagène est une protéine formée de trois chaînes polypeptidiques disposées hélicoïdalement. La glycine représente près d'un tiers des acides aminés présents dans le collagène. Le collagène contient également un taux élevé de proline et d'hydroxyproline. Il existe différents types de collagène, par exemple le collagène de type I ou de type II. Le collagène de type I est le plus répandu, il provient essentiellement de la peau, des os et des tendons. Le collagène de type II provient essentiellement des cartilages. Le collagène utilisé peut être de tout type et, de préférence, n'a pas été modifié chimiquement. Selon un mode de réalisation préféré de l'invention, le collagène utilisé est du collagène de type I.

La quantité minimale de collagène dans la composition est de 1% en masse par rapport à l'eau. Par exemple, la quantité de collagène utilisée est comprise entre 1 et 5% en masse, de préférence entre 2 et 4 %. Selon un mode de réalisation, la quantité de collagène utilisée est égale à la quantité maximale de collagène soluble dans l'eau.

Le photoinitiateur est soluble dans l'eau, apte à être excité à deux photons et capable de générer de l'oxygène singulet. Par « soluble dans l'eau », on entend, par exemple, soluble dans l'eau à 20°C à une concentration d'au moins 1 mg/mL. Par exemple, le photoinitiateur est soluble dans l'eau à une concentration comprise entre 1 et 100 mg/mL, ou entre 1 et 50 mg/mL, ou encore entre 1 et 10 mg/mL.

« Apte à être excité par plusieurs photons » signifie apte à absorber simultanément deux photons ou plus. Le photoinitiateur n'absorbe pas à un photon à la longueur d'onde de la source lumineuse utilisée. En d'autres termes, le photoinitiateur est transparent à la longueur d'onde de la source lumineuse utilisée.

Selon un mode de réalisation de l'invention, le photoinitiateur est choisi parmi les complexes de métaux de transition, de préférence parmi les complexes de ruthénium (II), osmium (II), iridium (III), palladium (II), platine (II), chrome (III) et leurs mélanges. De préférence, le photoinitiateur est un complexe de ruthénium (II).

Le complexe de métal de transition peut comprendre un ou plusieurs ligands. Lorsque le complexe comprend plusieurs ligands, ceux-ci peuvent être identiques ou différents. De préférence, le ligand est choisi parmi les bipyrydines, la 1,10-phénantroline, la bipyrazine, la diphényl-1,10-phénantroline, la diphényl-1,10-phénantroline-4,7-disulphonate, la 1,10-phénantroline-5-octadecanamide et leurs mélanges.

De manière particulièrement préférée, le photoinitiateur utilisé est du dichlorotris(1,10-phénantroline)ruthénium(II).

Le photoinitiateur est utilisé dans la composition à une quantité minimale de 0,5% en masse par rapport à l'eau. Par exemple, la quantité de photoinitiateur utilisée est comprise entre 0.5 et 10% en masse par rapport à l'eau, de préférence entre 1 et 5% en masse. De manière particulièrement préférée, la quantité de photoinitiateur utilisée est comprise entre 1 et 2% en masse.

Un promoteur d'adhésion cellulaire peut être ajouté à la composition. De préférence, le promoteur d'adhésion cellulaire ajouté est de la fibronectine. Dans le cas de la fibronectine, une quantité comprise entre 0,01 et 0,2 % en masse par rapport à l'eau peut être utilisée. De manière particulièrement préférée, la quantité de fibronectine est comprise entre 0,05 et 0,15 %.

La composition photosensible peut également comprendre au moins un composé actif. Par composé actif, on entend par exemple un composé ayant une activité biologique ou un composé ayant un intérêt médical ou un composé pharmaceutique.

De préférence, l'eau utilisée est de l'eau désionisée. L'eau désionisée peut être de l'eau distillée ou de l'eau bipermutée. L'eau bipermutée est obtenue par exemple en faisant passer de l'eau sur une résine échangeuse de cations et une résine échangeuse d'anions de façon à ce qu'elle ne contienne plus que des ions H⁺ et OH⁻.

L'invention concerne aussi un procédé d'obtention de la composition photosensible susvisée. Ce procédé comprend les étapes essentielles suivantes :
- préparation d'un mélange de gélatine, de collagène, de photoinitiateur, éventuellement du promoteur d'adhérence cellulaire, et d'eau,
- chauffage du mélange à une température comprise entre 30 et 60°C, de préférence comprise entre 40 et 50°C, jusqu'à dissolution des composés dans l'eau,
- refroidissement à température ambiante de la composition, ce qui entraîne la formation d'un gel.

La composition se présente sous forme de gel à température ambiante et sous forme liquide lorsqu'elle est chauffée à plus de 40°C. La composition sous forme de gel peut être conservée plusieurs semaines au réfrigérateur. Par ailleurs, la composition sous forme de gel est particulièrement adaptée à la production de structures tridimensionnelles par absorption multiphotonique. En effet, elle limite grandement le mouvement de la structure en court de réticulation par le laser et ainsi garantit une structure finale non-déformée et fidèle au modèle tridimensionnel.

L'invention a également pour objet une structure tridimensionnelle produite avec la composition photosensible décrite ci-dessus. Selon un mode de réalisation de l'invention, la structure tridimensionnelle a une dimension de l'ordre de quelques µm. Selon un autre mode de réalisation, la structure tridimensionnelle a une dimension de l'ordre de quelques mm.

Selon un mode de réalisation de l'invention, la structure tridimensionnelle a une épaisseur de trait comprise entre 0.5 et 6 µm, de préférence entre 1 et 5 µm. Par « épaisseur de trait », on entend, par exemple, l'épaisseur de la ligne obtenue lorsque l'on trace une ligne avec le faisceau laser focalisé dans la formulation. L'épaisseur de trait étant très faible, la structure tridimensionnelle souhaitée peut comporter des parties dont les plus petits détails seront de dimensions égales à l'épaisseur de trait.

La structure tridimensionnelle peut être conservée plusieurs semaines dans de l'eau ou dans un tampon biologique de type tampon phosphate.

L'ajout de collagène permet de renforcer la structure tridimensionnelle et de lui conférer de bonnes propriétés mécaniques. La rigidité de la structure tridimensionnelle peut être contrôlée en modifiant la quantité de collagène présente dans la composition photosensible.

La structure tridimensionnelle n'a pas d'impact négatif sur la croissance des cellules. De préférence, la structure tridimensionnelle est biocompatible et/ou biodégradable et/ou biorésorbable, elle peut donc être utilisée comme matrice pour la culture cellulaire. Par « biocompatible », on entend, par exemple, qui ne dégrade pas et n'interfère pas avec le milieu dans lequel il est utilisé. Par « biodégradable », on entend, par exemple, au moins en partie décomposable par le milieu dans lequel il est utilisé. Par « biorésorbable », on entend, par exemple, qui peut être résorbé et métabolisé entièrement par le milieu dans lequel il est utilisé.

L'invention a également pour objet une matrice pour la culture cellulaire qui comprend une structure tridimensionnelle telle que décrite ci-dessus. Par « matrice pour la culture cellulaire », on entend, par exemple, une structure tridimensionnelle poreuse, qui peut être utilisée pour cultiver des cellules hors de leur organisme ou de leur milieu d'origine.

L'invention a également pour objet un procédé de fabrication d'une structure tridimensionnelle comprenant les étapes suivantes :
- prélèvement d'une aliquote de composition photosensible décrite ci-dessus,
- exposition d'une partie de l'aliquote à une source lumineuse de longueur d'onde adéquate et d'intensité suffisante pour induire la réticulation par absorption multiphotonique,
- rinçage des parties non réticulées dans de l'eau à une température comprise entre 35 et 40°C.

Le rinçage des parties non réticulées produit un gonflement de la structure tridimensionnelle qui a été fabriquée. Ainsi, les dimensions de la structure sont augmentées par rapport à la structure fabriquée initialement.

Selon un mode de réalisation de l'invention, le prélèvement d'une aliquote de composition photosensible est effectué de la façon suivante :
- chauffage de la composition photosensible à une température comprise entre 30°C et 60°C, de préférence 40 et 50°C, pendant une durée comprise entre 10 minutes et 1 heure, de préférence entre 15 et 45 minutes et encore plus préférentiellement entre 25 et 35 minutes,
- prélèvement d'une goutte de la composition photosensible,
- dépôt sur une plaque, de préférence une plaque de verre,
- refroidissement jusqu'à obtention d'un gel.

Toute source lumineuse ayant une longueur d'onde adéquate et une intensité suffisante pour induire la réticulation par absorption multiphotonique peut être utilisée. La source lumineuse doit avoir une longueur d'onde adaptée au photoinitiateur, c'est-à-dire que le photoinitiateur doit pouvoir absorber à deux photons ou plus à la longueur d'onde de la source lumineuse. La longueur d'onde de la source lumineuse est généralement comprise entre 300 et 1500 nm. Selon un mode de réalisation préféré de l'invention, la source lumineuse utilisée est un laser. Selon un mode de réalisation préféré de l'invention, le laser est impulsionnel et fournit des impulsions de durée inférieure à 1 nanoseconde. De préférence, le laser a une longueur d'onde de 532, 780 ou 1064 nm.

La réticulation est induite lorsque la partie de l'aliquote exposée à la source lumineuse n'est pas dissoute en la plaçant dans de l'eau bipermutée à une température comprise entre 30 et 55°C pendant une durée comprise entre 10 minutes et 1 heure.

Selon un mode de réalisation de l'invention, la fabrication de structures tridimensionnelles est effectuée en utilisant une optique de focalisation et un laser. De préférence, l'optique de focalisation est un microscope, par exemple un microscope inversé.

La réticulation est localisée uniquement au point focal de la source lumineuse, c'est à dire dans un faible volume d'un échantillon (voxel). Ainsi, en utilisant un logiciel de conception assistée par ordinateur et en déplaçant l'échantillon selon les 3 axes x, y et z, il est possible de fabriquer la structure tridimensionnelle que l'on souhaite. La structure a ainsi une architecture contrôlée et reproductible.

Selon un mode de réalisation de l'invention, le rinçage des parties non réticulées peut être effectué en plaçant l'échantillon pendant une durée comprise entre 10 minutes et 1 heure, de préférence entre 15 et 45 minutes et encore plus préférentiellement entre 25 et 35 minutes, dans de l'eau bipermutée à une température comprise entre 30 et 55°C, de préférence entre 35 et 40°C.

Selon un mode de réalisation de l'invention la puissance laser est comprise entre 1 et 2,5 mW, de préférence entre 1,5 et 2 mW, par exemple 1.5 mW. Les temps d'exposition sont compris entre 1 et 10 ms par voxel, ce qui correspond à des vitesses de balayage du faisceau laser comprises entre 150 et 15 µm/s. Préférentiellement, les vitesses de balayage sont comprises entre 100 et 15 µm/s, encore plus préférentiellement entre 20 et 40 µm/s.

Selon un mode de réalisation de l'invention, le procédé comprend plusieurs expositions d'une même partie de l'aliquote à une source lumineuse de longueur d'onde adéquate et d'intensité suffisante pour induire la réticulation par absorption multiphotonique. Ainsi, il est possible d'effectuer plusieurs passages successifs sur une partie déjà réticulée, par exemple entre 2 et 10 passages ou entre 4 et 6. Cela permet d'augmenter le taux de réticulation, ce qui permet de limiter le gonflement de la structure au cours de l'étape de rinçage. La structure est donc mieux résolue et l'épaisseur de trait est diminuée. Par exemple pour les lignes horizontales, et après rinçage, l'épaisseur de trait est voisine de 5 µm après le premier passage. Elle diminue à 4,5 µm après le troisième passage pour se situer aux environs de 4 µm après le cinquième passage. Augmenter le nombre de passage permet d'obtenir une structure mieux résolue (lignes plus fines) mais aussi mieux réticulée et donc moins déformée au cours de l'étape de rinçage.

Dans le cas où un microscope inversé est utilisé, le fait d'avoir une composition solide sous forme de gel permet un balayage du laser de l'intérieur de la composition vers sa base, c'est à dire que l'on peut former la structure en commençant par le haut de cette dernière. Cela permet d'éviter les risques de défocalisation du laser par les parties de la composition déjà réticulées et aussi limite le mouvement de la structure en court de réticulation par le laser.

### EXEMPLES :

Des structures tridimensionnelles sont fabriquées en utilisant un microscope inversé classique utilisant un objectif x 100 (ouverture numérique 1,25) couplé au kit de microfabrication µFAB-3D commercialisé par Teemphotonics. La source lumineuse utilisée est un laser impulsionnel ayant une longueur d'onde de 532 nm.
Pour ce faire, un échantillon de composition photosensible est placé sur une lame de microscope classique (25 x 25 mm et 170 µm d'épaisseur) prétraitée avec du PlusOne Bind Silane de GE Healthcare afin d'assurer l'adhérence des structures.
L'épaisseur de trait des lignes est mesurée après rinçage des parties non réticulées.

La composition photosensible est obtenue à partir de gélatine de type B obtenue à partir de peaux de bovins acheté chez Sigma-Aldrich, de collagène de type I obtenu à partir de queue de rat acheté chez Sigma-Aldrich, de dichlorotris(1,10-phénantroline)ruthénium(II) comme photoinitiateur, éventuellement de fibronectine acheté chez Sigma-Aldrich et d'eau bipermutée.

### 1) Préparation de la composition photosensible

### Exemple 1 : Composition photosensible sans promoteur d'adhérence

A 10 mL d'eau bipermutée sont ajoutés 2 g de de gélatine de type B, 300 mg de collagène de type I et 100 mg de dichlorotris(1,10-phénantroline)ruthénium(II).
Ce mélange est agité au bain marie à 40°C jusqu'à dissolution complète (environ 1 heure). Après retour à température ambiante, la composition photosensible se présente sous la forme d'un gel solide.

### Exemple 2 : Composition photosensible avec promoteur d'adhérence

Une composition photosensible avec promoteur d'adhérence est obtenue selon le mode opératoire décrit dans l'exemple 1 en rajoutant 10 mg de fibronectine au mélange.

### 2) Fabrication de la structure tridimensionnelle

### Exemple 3 : Structure tridimensionnelle sans promoteur d'adhérence

Une aliquote de la composition obtenue selon l'exemple 1 est prélevée et chauffée au bain-marie à 40°C pendant 30 minutes sous agitation. La composition photosensible est alors à l'état liquide.

Une goutte de cette composition photosensible à l'état liquide est prélevée et déposée sur une lame de microscope. Après retour à température ambiante, la composition est à nouveau sous forme de gel, l'échantillon est prêt.

Une structure de type « cage à poules », avec une maille de 11x11 µm est fabriquée en utilisant une puissance laser voisine de 1,9 mW, une vitesse de balayage proche de 30µm/s, un temps d'exposition de 5 ms et en effectuant 5 passage successifs du laser sur les parties à réticuler.

Après fabrication de la structure tridimensionnelle, l'échantillon est placé pendant 30 minutes dans de l'eau bipermutée à 37°C, de manière à dissoudre les parties non réticulées.

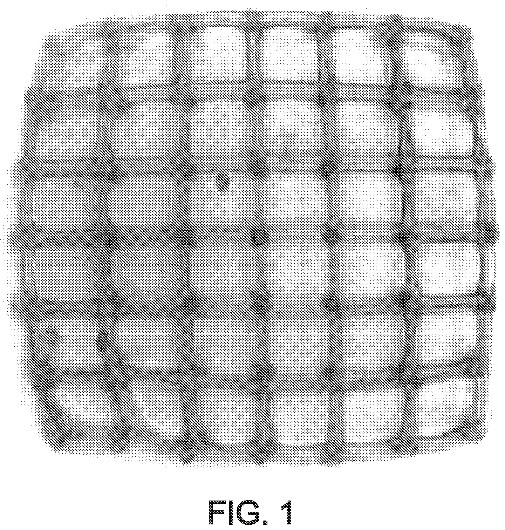

La figure 1 montre la structure obtenue au microscope. Suite au gonflement de la structure, celle-ci possède une hauteur de 100 µm et une longueur de côté de 115 µm.

L'épaisseur de trait des lignes horizontales est comprise entre 3,8 et 4,2 micromètres celle des lignes verticales entre 2 et 2,5 µm.

Cette figure montre que des structures tridimensionnelles précises peuvent être fabriquées avec cette composition photosensible.

### Exemple 4 : Structure tridimensionnelle avec promoteur d'adhérence

Une structure de type « cage à poules », avec une maille de 15x15 µm est fabriquée selon le mode opératoire décrit dans l'exemple 3 en utilisant la composition obtenue selon l'exemple 2.

### 3) Tests en culture cellulaire

Des structures obtenues selon l'exemple 4 ont été testées en culture cellulaire. Des cellules cancéreuses de type T24 ont été mises en culture pendant 48 heures avec ces structures. Les conditions de culture sont des conditions standards. Après 48 heures, les cellules ont été fixées avec une solution à 2% de paraformaldéhyde et les noyaux ont été colorés avec du Hoescht.

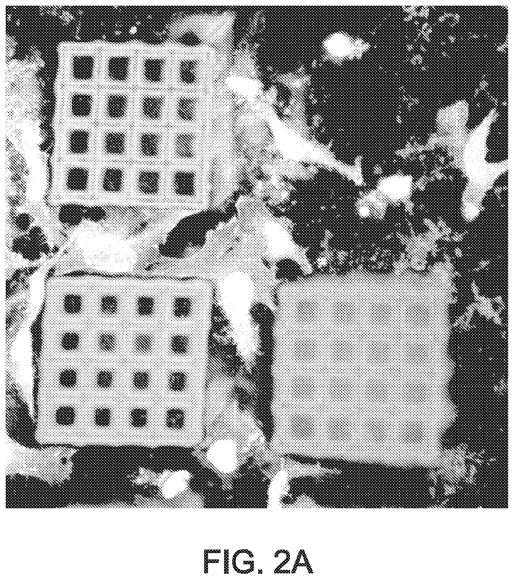

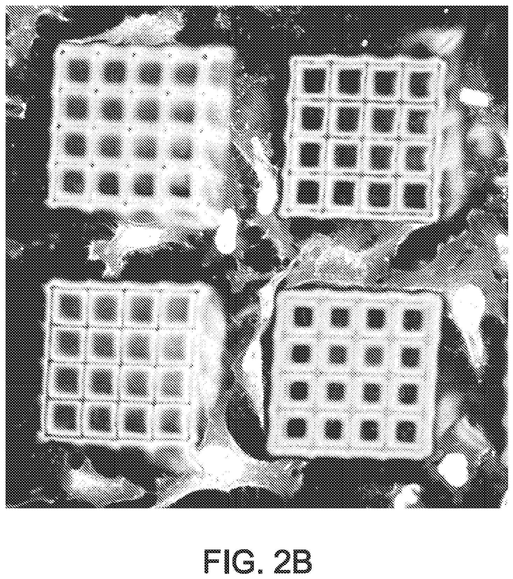

Les figures 2A et 2B montrent les structures tridimensionnelles et les cellules au microscope confocal. La figure 2A montre trois structures tridimensionnelles ayant l'apparence de grilles entourées par des cellules blanchâtres et la figure 2B montre quatre structures tridimensionnelles ayant l'apparence de grilles entourées par des cellules blanchâtres. Les cellules et les structures tridimensionnelles sont bien visibles et le taux de mortalité des cellules après 48 h de culture est normal. Les cellules cultivées tolèrent donc très bien les structures tridimensionnelles fabriquées, ce qui témoigne de la biocompatibilité de ces structures.

## Revendications

1. Composition photosensible activable par absorption multiphotonique comprenant :
- de la gélatine,
- du collagène,
- un photoinitiateur soluble dans l'eau, apte à être excité par plusieurs photons et capable de générer de l'oxygène singulet,
- éventuellement un promoteur d'adhérence cellulaire,
- et de l'eau.

2. Composition photosensible selon la revendication 1 **caractérisée en ce qu'**elle comprend une quantité de gélatine comprise entre 10 et 50% en masse par rapport à l'eau, de préférence entre 10 et 30% et encore plus préférentiellement entre 15 et 25%.

3. Composition photosensible selon la revendication 1 ou 2 **caractérisée en ce qu'**elle comprend une quantité de collagène comprise entre 1 et 5% en masse par rapport à l'eau, de préférence entre 2 et 4 %.

4. Composition photosensible selon l'une quelconque des revendications précédentes **caractérisée en ce qu'**elle comprend une quantité de photoinitiateur comprise entre 0.5 et 10% en masse par rapport à l'eau, de préférence entre 1 et 5% et encore plus préférentiellement entre 1 et 2%.

5. Composition photosensible selon l'une quelconque des revendications précédentes **caractérisée en ce que** le photoinitiateur est choisi parmi les complexes de métaux de transition, de préférence choisi parmi les complexes de ruthénium (II), osmium (II), iridium (III), palladium (II), platine (II), chrome (III) et leurs mélanges.

6. Composition photosensible selon l'une quelconque des revendications précédentes **caractérisée en ce que** le photoinitiateur est le dichlorotris(1,10-phénantroline)ruthénium(II).

7. Composition photosensible selon l'une quelconque des revendications précédentes **caractérisée en ce qu'**elle se présente sous forme de gel à température ambiante et sous forme liquide lorsqu'elle est chauffée à plus de 40°C.

8. Composition photosensible selon l'une quelconque des revendications précédentes **caractérisée en ce qu'**elle comprend en outre un composé actif.

9. Procédé de préparation d'une composition photosensible selon l'une quelconque des revendications ci-dessus **caractérisé en ce qu'**il comprend les étapes essentielles suivantes :
- préparation d'un mélange de gélatine, de collagène, de photoinitiateur et d'eau,
- chauffage du mélange à une température comprise entre 30 et 60°C, de préférence comprise entre 40 et 50°C, jusqu'à dissolution des composés dans l'eau,
- refroidissement à température ambiante de la composition, ce qui entraîne la formation d'un gel.

10. Structure tridimensionnelle **caractérisée en ce qu'**elle est produite à partir d'une composition photosensible selon l'une quelconque des revendications 1 à 8.

11. Structure tridimensionnelle selon la revendication 10 **caractérisée en ce qu'**elle a une épaisseur de trait comprise entre 1 et 5 µm.

12. Matrice pour la culture cellulaire **caractérisée en ce qu'**elle comprend une structure tridimensionnelle selon la revendication 10 ou 11.

13. Procédé de préparation d'une structure tridimensionnelle selon la revendication 10 ou 11 **caractérisé en ce qu'**il comprend les étapes essentielles suivantes :
- prélèvement d'une aliquote de composition photosensible,
- exposition d'une partie de l'aliquote à une source lumineuse de longueur d'onde adéquate et d'intensité suffisante pour induire la réticulation par absorption multiphotonique,
- rinçage des parties non réticulées.

14. Procédé selon la revendication 13 **caractérisé en ce que** la source lumineuse est un laser, de préférence un laser ayant une longueur d'ondes de 532, 780 ou 1062 nm, de préférence un laser impulsionnel avec une durée d'impulsion inférieure à 1 nanoseconde.

15. Procédé selon la revendication 13 ou 14 **caractérisé en ce que** le rinçage des parties non réticulées est effectué en plaçant l'aliquote pendant une durée comprise entre 10 minutes et 1 heure, de préférence entre 15 et 45 minutes et encore plus préférentiellement entre 25 et 35 minutes, dans de l'eau de préférence bipermutée à une température comprise entre 30 et 55°C, de préférence entre 35 et 40°C.

## Patentansprüche

1. Lichtempfindliche Zusammensetzung, die durch Multi-Photonen-Absorption aktiviert werden kann, umfassend:
- Gelatine,
- Kollagen,
- einen wasserlöslichen Photoinitiator, der durch mehrere Photonen angeregt werden kann und in der Lage ist, Singulett-Sauerstoff zu erzeugen,
- gegebenenfalls einen Zelladhäsions-Promoter,
- und Wasser.

2. Lichtempfindliche Zusammensetzung nach Anspruch 1, **dadurch gekennzeichnet, dass** sie auf das Wasser bezogen eine Gelatinemenge im Bereich zwischen 10 und 50 Masse-%, vorzugsweise zwischen 10 und 30 % und noch stärker bevorzugt zwischen 15 und 25 % umfasst.

3. Lichtempfindliche Zusammensetzung nach Anspruch 1 oder 2, **dadurch gekennzeichnet, dass** sie auf das Wasser bezogen eine Kollagenmenge im Bereich zwischen 1 und 5 Masse-%, vorzugsweise zwischen 2 und 4 % umfasst.

4. Lichtempfindliche Zusammensetzung nach einem der vorstehenden Ansprüche, **dadurch gekennzeichnet, dass** sie auf das Wasser bezogen eine Photoinitiatormenge im Bereich zwischen 0,5 und 10 Masse-%, vorzugsweise zwischen 1 und 5 %, und noch stärker bevorzugt zwischen 1 und 2 % umfasst.

5. Lichtempfindliche Zusammensetzung nach einem der vorstehenden Ansprüche, **dadurch gekennzeichnet, dass** der Photoinitiator aus Übergangsmetallkomplexen ausgewählt ist, vorzugsweise ausgewählt aus Ruthenium(II)-, Osmium(II)-, Iridium(III)-, Palladium(II)-, Platin(II)-, Chrom(III)-Komplexen und deren Mischungen.

6. Lichtempfindliche Zusammensetzung nach einem der vorstehenden Ansprüche, **dadurch gekennzeichnet, dass** es sich beim Photoinitiator um Dichlortris(1,10-phenanthrolin)ruthenium(II) handelt.

7. Lichtempfindliche Zusammensetzung nach einem der vorstehenden Ansprüche, **dadurch gekennzeichnet, dass** sie bei Raumtemperatur in Gelform und, wenn sie auf mehr als 40 °C erwärmt wird, in flüssiger Form vorliegt.

8. Lichtempfindliche Zusammensetzung nach einem der vorstehenden Ansprüche, **dadurch gekennzeichnet, dass** sie weiter eine aktive Verbindung umfasst.

9. Verfahren zur Herstellung einer lichtempfindlichen Zusammensetzung nach einem der obenstehenden Ansprüche, dadurch gegenzeichnet, dass es die folgenden wesentlichen Schritte umfasst:
- Herstellen einer Mischung aus Gelatine, Kollagen, Photoinitiator und Wasser,
- Erwärmen der Mischung auf eine Temperatur im Bereich zwischen 30 und 60 °C, vorzugsweise im Bereich zwischen 40 und 50 °C, bis zur Auflösung der Verbindungen im Wasser,
- Abkühlen der Zusammensetzung auf Raumtemperatur, was zur Bildung eines Gels führt.

10. Dreidimensionale Struktur, **dadurch gekennzeichnet, dass** sie auf Grundlage einer lichtempfindlichen Zusammensetzung nach einem der Ansprüche 1 bis 8 produziert wird.

11. Dreidimensionale Struktur nach Anspruch 10, **dadurch gekennzeichnet, dass** sie eine Liniendicke im Bereich zwischen 1 und 5 µm aufweist.

12. Zellkulturmatrix, **dadurch gekennzeichnet, dass** sie eine dreidimensionale Struktur nach Anspruch 10 oder 11 umfasst.

13. Verfahren zur Herstellung einer dreidimensionalen Struktur nach Anspruch 10 oder 11, **dadurch gekennzeichnet, dass** es die folgenden wesentlichen Schritte umfasst:
- Entnehmen eines Aliquots der lichtempfindlichen Zusammensetzung,
- Aussetzen eines Teils des Aliquots einer Lichtquelle mit einer Wellenlänge, die geeignet ist, und einer Stärke, die ausreichend ist, um die Vernetzung durch Multi-Photonen-Absorption einzuleiten,
- Abspülen der nicht vernetzten Teile.

14. Verfahren nach Anspruch 13, **dadurch gekennzeichnet, dass** es sich bei der Lichtquelle um einen Laser handelt, vorzugsweise einen Laser, der eine Wellenläge von 532, 780 oder 1062 nm aufweist, vorzugsweise einen Pulslaser mit einer Pulsdauer von weniger als 1 Nanosekunde.

15. Verfahren nach Anspruch 13 oder 14, **dadurch gekennzeichnet, dass** das Abspülen der nicht vernetzten Teile durch Geben des Aliquots für eine Dauer im Bereich zwischen 10 Minuten und 1 Stunde, vorzugsweise zwischen 15 und 45 Minuten, und noch stärker bevorzugt zwischen 25 und 35 Minuten in vorzugsweise bi-permutiertes Wasser mit einer Temperatur im Bereich zwischen 30 und 55 °C, vorzugsweise zwischen 35 und 40 °C vorgenommen wird.

## Claims

1. Photosensitive composition that can be activated by multiphoton absorption comprising:
- gelatin,
- collagen,
- a water-soluble photoinitiator, suitable for being excited by several photons and capable of generating singlet oxygen,
- optionally a cell adhesion promoter,
- and water.

2. Photosensitive composition according to claim 1 **characterised in that** it comprises a quantity of gelatin of between 10 and 50% by mass with respect to water, preferably between 10 and 30% and more preferentially between 15 and 25%.

3. Photosensitive composition according to claim 1 or 2 **characterised in that** it comprises a quantity of collagen of between 1 and 5% by mass with respect to water, preferably between 2 and 4%.

4. Photosensitive composition according to any one of the preceding claims **characterised in that** it comprises a quantity of photoinitiator of between 0.5 and 10% by mass with respect to water, preferably between 1 and 5% and more preferentially between 1 and 2%.

5. Photosensitive composition according to any one of the preceding claims **characterised in that** the photoinitiator is chosen among the complexes of transition metals, preferably chosen among the complexes of ruthenium (II), osmium (li), iridium (III), palladium (II), platinum (II), chromium (III) and mixtures thereof.

6. Photosensitive composition according to any one of the preceding claims **characterised in that** the photoinitiator is dichlorotris(1,10-phenanthroline)ruthenium(II).

7. Photosensitive composition according to any one of the preceding claims **characterised in that** it is presented in gel form at ambient temperature and in liquid form when it is heated to over 40°C.

8. Photosensitive composition according to any one of the preceding claims **characterised in that** it further comprises an active compound.

9. Process for preparing a photosensitive composition according to any one of the above claims **characterised in that** it comprises the following essential steps:
- preparing a mixture of gelatin, collagen, photoinitiator and water,
- heating the mixture to a temperature of between 30 and 60°C, preferably between 40 and 50°C, until dissolution of the compounds in water,
- cooling the composition to ambient temperature, which induces the formation of a gel.

10. Three-dimensional structure **characterised in that** it is produced from a photosensitive composition according to any one of claims 1 to 8.

11. Three-dimensional structure according to claim 10 **characterised in that** it has a line thickness of between 1 and 5 µm .

12. Cell culture matrix **characterised in that** it comprises a three-dimensional structure according to claim 10 or 11.

13. Process for preparing a three-dimensional structure according to claim 10 or 11 **characterised in that** it comprises the following essential steps:
- sampling an aliquot of photosensitive composition,
- exposing a portion of the aliquot to a light source of suitable wavelength and sufficient intensity to induce cross-linking by multiphoton absorption,
- rinsing the non-cross-linked portions.

14. Process according to claim 13 **characterised in that** the light source is a laser, preferably a laser having a wavelength of 532, 780 or 1062 nm, preferably a pulsed laser with a pulse duration of less than 1 nanosecond.

15. Process according to claim 13 or 14 **characterised in that** the rinsing of the non-cross-linked portions is performed by placing the aliquot for a time of between 10 minutes and 1 hour, preferably between 15 and 45 minutes and more preferentially between 25 and 35 minutes, in preferably bi-permuted water at a temperature between 30 and 55°C, preferably between 35 and 40°C.
